# EUROPEAN PATENT SPECIFICATION

(11) **EP 0 455 229 B1**
(45) Date of publication and mention of the grant of the patent: **15.10.1997**
(21) Application number: 91107032.4
(22) Date of filing: 30.04.1991
(51) Int. Cl.: H01L 23/498, H01L 23/15, H01L 21/48

(54) **Ceramic substrate used for an electric or electronic circuit**
Keramisches Substrat verwendet für eine elektrische oder elektronische Schaltung
Substrat céramique utilisé pour un circuit électrique ou électronique

(30) Priority: 02.05.1990 JP 116162/90; 11.05.1990 JP 121754/90; 23.08.1990 JP 221988/90
(43) Date of publication of application: 06.11.1991
(73) Proprietor: MITSUBISHI MATERIALS CORPORATION, Chiyoda-ku Tokyo (JP)
(72) Inventor: Yoshida, Hideaki, c/o Mitsubishi Materials Corp., Omiya-shi, Saitama (JP); Toriumi, Makoto, c/o Mitsubishi Materials Corp., Omiya-shi, Saitama (JP); Tanaka, Hirokazu, c/o Mitsubishi Materials Corp., Omiya-shi, Saitama (JP); Umezawa, Masao, c/o Mitsubishi Materials Corp., Omiya-shi, Saitama (JP); Yuzawa, Michio, c/o Mitsubishi Materials Corp., Omiya-shi, Saitama (JP); Kuromitsu, Yoshirou, c/o Mitsubishi Materials Corp, Omiya-shi, Saitama (JP)
(74) Representative: Pätzold, Herbert, Dr.-Ing.

(56) References cited:
- EP-A- 0 097 944
- EP-A- 0 422 558
- US-A- 4 865 877
- PATENT ABSTRACTS OF JAPAN vol. 13, no. 186 (E-752)2 May 1989 & JP-A-01 012 559
- PATENT ABSTRACTS OF JAPAN vol. 12, no. 54 (E-583)18 February 1988 & JP-A-62 199 038
- PATENT ABSTRACTS OF JAPAN vol. 14, no. 90 (C-691)20 February 1990 & JP-A-01 301 575
- PATENT ABSTRACTS OF JAPAN vol. 14, no. 292 (E-944)25 June 1990 & JP-A-02 094 652
- PATENT ABSTRACTS OF JAPAN vol. 13, no. 166 (E-746)20 April 1989 & JP-A-63 318 760
- PATENT ABSTRACTS OF JAPAN vol. 13, no. 396 (E-815)4 September 1989 & JP-A-01 140 693
- MACHINE DESIGN. vol. 61, no. 24, 23 November 1989, CLEVELAND US pages 95 - 100; J. INTRATER: 'The Callenge of Bonding Metals to Ceramics'

## Description

This invention relates to a ceramic substrate used for an electric or electronic circuit and, according to the introductory portion of claim 1.

### BACKGROUND OF THE INVENTION

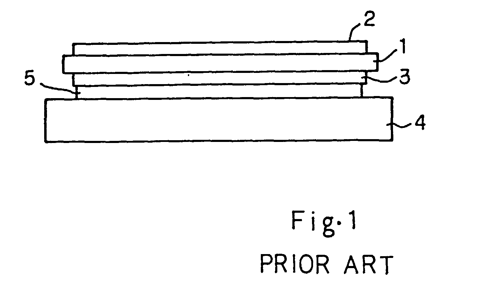

A typical example of the ceramic substrate is illustrated in Fig. 1 and comprises a ceramic plate 1 of aluminum oxide sandwiched between two copper plates 2 and 3, and a heat sink 4 of copper. The copper plates 2 and 3 are bonded to both surfaces of the ceramic plate 1 through a liquid phase bonding phenomenon. Namely, the bonding surfaces of the copper plates 2 and 3 are firstly oxidized, and the ceramic plate 1 is laminated with the copper plates 2 and 3 on both surfaces thereof. While the ceramic plate laminated with the copper plates 2 and 3 are heated at 1065 to 1085 degrees in centigrade, the copper and the copper oxide are melted, and the copper plates 2 and 3 are bonded to the ceramic plate 1 through a copper-and-copper oxide eutectic phenomenon. One of the copper plates 2 and 3 provides a conduction path between circuit components, and the other is soldered to the heat sink member 4 at lower than 450 degrees in centigrade.

A problem inherent in the prior art ceramic substrate is a small resistance against stress of thermal fatigue. When the electric or electronic circuit is activated for a task, a large amount of heat is produced in the circuit components, and the ceramic substrate conducts the heat for radiating. Since the copper plates 2 and 3 are different in thermal expansion coefficient from the ceramic plate 1, the ceramic plate is subjected to thermal stress. Upon being inactivated, no heat is produced, and the ceramic plate is released from the thermal stress. Thus, heat cycle takes place in the electric or electronic circuit. Since the aluminum oxide plate 1 and the copper plates 2 and 3 are rigidly coupled through the copper-and-copper oxide eutectic phenomenon, the ceramic substrate is repeatedly subjected to the thermal stress. The thermal stress is causative of cracks in the ceramic plate 1, and the ceramic substrate is broken in the worst case.

A ceramic substrate used for an electric or electronic circuit, which comprises a ceramic plate formed of a substance mainly composed of aluminium nitride and conductive islands formed of aluminium or an aluminium alloy and bonded to one surface of said ceramic plate for providing conductive path to circuit components, which aluminium or aluminium alloy islands decrease the total weight of the ceramic substrate and enhance a resistance against repitition of thermal stress, is the subject of the earlier application EP-A-0 422 558.

Further ceramic substrates used for an electric or electronic circuit, comprising a ceramic plate mainly formed of aluminium nitride are known from JP-A-01-012559, JP-A-02-094 652 and JP-A-63-318 760.

In EP-A-0 097 944 a method of directly bonding a ceramic member and a metal member is disclosed, whereby an oxidation treatment process is used. US-A-4 865 877 discloses that the adhesion between a ceramic substrate and metallic plates is influenced by a certain surface roughness.

It is an important object of the present invention to provide a ceramic substrate which is large in resistance against the reptition of thermal stress.

In accordance with the present invention said object is obtained with the features of the characterizing portion of claim 1.

The features and advantages of a ceramic substrate according to the present invention will be more clearly understood from the following description taken in conjunction with the accompanying drawings in which:
Fig. 1 is a side view showing the structure of the prior art ceramic substrate;
Fig. 2 is a cross sectional view showing the structure of another ceramic substrate
Fig. 3 is a cross sectional view showing the structure of a ceramic substrate according to the present invention, which is a modification of the ceramic substrate shown in Fig. 2; and
Figs. 4A to 4C are views showing grains of aluminum nitride forming a surface portion of a ceramic plate of the ceramic substrate according to the present invention shown in Fig. 3.

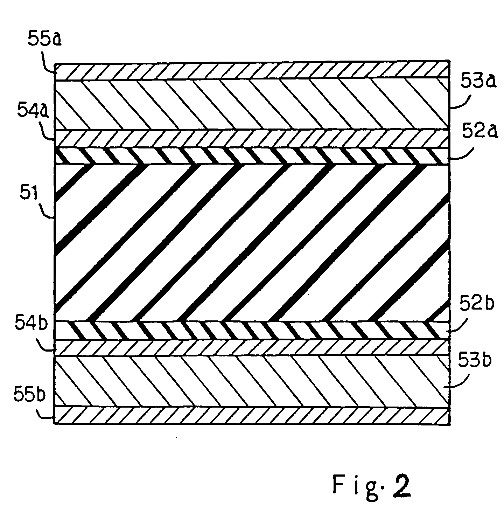

Turning to Fig. 2 of the drawings, another ceramic substrate comprises a ceramic plate 51 of aluminum nitride, ceramic plates 52a and 52b of silicon carbide provided on both surfaces of the ceramic plate 51, metallic plates 53a and 53b of aluminum respectively brazed to the ceramic plates 52a and 52b with brazing alloy films 54a and 54b, and nickel films 55a and 55b covering the metallic plates 53a and 53b, respectively. The nickel films 55a and 55b are replaceable with copper films, and the metallic plates 53a and 53b may be formed of an aluminum alloy such as, for example, an aluminum manganese, an aluminum nickel or an aluminum boron alloy. Electric or electronic circuit components (not shown) are provided on at least one nickel film 55a or 55b, and a heat sink may be bonded to the other of the nickel films 55a and 55b. The brazing alloy films 54a and 54b are formed of a substance selected from an aluminum-silicon alloy, an aluminum-germanium alloy and aluminum-copper alloy.

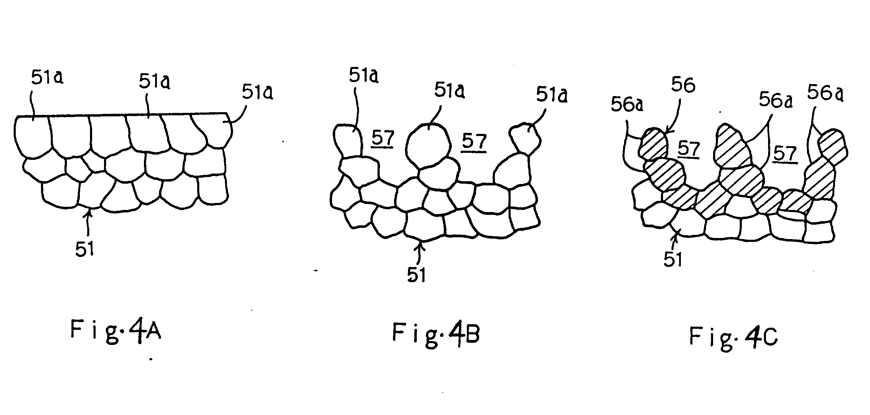

Aluminum nitride has heat conductivity ranging from 50 watt/ mK to 270 watt/ mK, and silicon carbide is as large in heat conductivity as 35 to 270 watt/ mK. These substances are larger in heat conductivity than aluminum oxide the heat conductivity of which is as small as 15 to 20 watt /mK. Thus, the ceramic substrate shown in Fig. 4 is fabricated from the high-heat conductive plates, and, for this reason, the ceramic substrate can radiate a large amount of heat due to the electric or electronic circuit.

Silicon carbide is affinitive to aluminum silicon alloy, and the brazing alloy films 54a and 54b are perfectly brazed to the ceramic plate 51.

The density of aluminum is as small as 2.7 to 2.8 gram /cm³, however, copper is 8.9 to 9.0 gram/ cm³ in density. The ceramic substrate shown in Fig. 2 is lighter than the prior art ceramic substrate using copper. The brazing films 54a and 54b are sufficiently deformable to take up a difference in the thermal expansion coefficient between the silicon carbide and the aluminum. For this reason, the ceramic substrate according to the present invention can well withstand against thermal stress due to heat cycle.

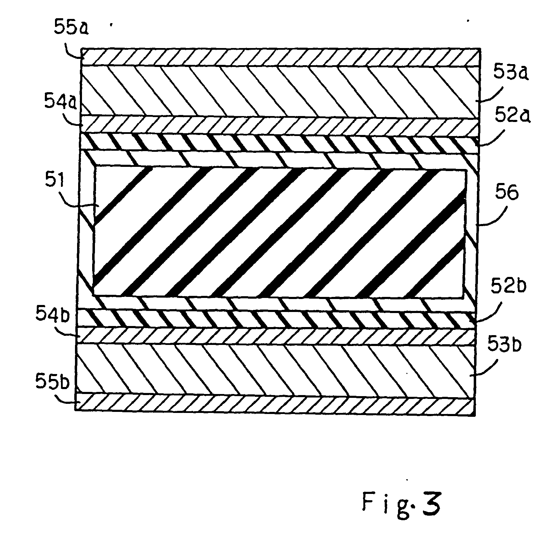

Fig. 3 shows a ceramic substrate according to the present invention which is a modification of the ceramic substrate shown in Fig. 2, and the same reference numerals designate component layers and films corresponding to those of the ceramic substrate shown in Fig. 2. In the modification, the surface of the ceramic plate 51 of aluminum nitride is eroded by acid solution or alkaline solution for forming a rough surface, and the rough surface is oxidized in a high-temperature oxidation ambience. The aluminum oxide film ranges from 0.05 micrometer to 30 micrometers. In the roughening process, the original surface of the ceramic plate 51 shown in Fig. 4A is attacked by an acid solution or an alkaline solution, and small recesses 57 take place in the rough surface as will be seen from Fig. 4B. The recesses 57 penetrate 1/2 time to 3 times larger than the size of grain 51a. After the oxidation, grains 56a, which are hatched in Fig. 4C, are oxidized in the high-temperature oxidation ambience, and the oxidized grains 56a form the aluminum oxide film 56.

Silicon carbide is deposited on the aluminum oxide film 56 by using a sputtering or a chemical vapor deposition to form ceramic plates 52a and 52b, and the ceramic plates 52a and 52b strongly adhere to the aluminum oxide film 56 by virtue of the rough surface. If the recesses 57 are shallower than a half of the grain size, the increment of surface area due to the roughening is too small to increase the adhesion. If the recesses 57 exceed the critical value three time larger than the grain size, spike-like grain clods tends to be crashed due to erosion of the grain boundaries, and the adhesion between the aluminum oxide film 56 and the ceramic plates 52a and 52b is decreased.

The thickness of the aluminum oxide film 56 deeply concerns the adhesion as well as the heat radiation. If the aluminum oxide film 56 is less than 0.05 micrometer, non-oxidized surface is exposed to the boundary between the aluminum oxide film 56 and the ceramic plates 52a and 52b, and decreases the adhesion. The aluminum oxide film 56 greater than 30 microns deteriorates the heat conduction characteristics of the ceramic substrate, because the aluminum oxide is smaller in heat conductivity than the aluminum nitride and the silicon carbide.

## Claims

1. A ceramic substrate used for an electric or electronic circuit comprising
a) a ceramic foundation (51/56/52a/52b) implemented by a ceramic plate (51) essentially composed of aluminum nitride (AlN), an aluminium oxide film (56) covering the surface of said ceramic plate (51) and having a thickness of about 0.05 micrometers to about 30 micrometers;
b) metallic plates (53a/55a) of a substance selected from the group consisting of aluminium and aluminium alloys bonded to one surface of said ceramic foundation and providing a conductive path for at least one circuit component connected thereto, said metallic plates being brazed to said one surface of said ceramic foundation with a brazing alloy (54a) selected from the group consisting of aluminium-silicon alloy, aluminium-germanium alloy and aluminium-copper alloy,
**characterized** in that
said surface of said aluminium nitride plate (51) is a rough surface with recesses (57), which penetrate into the surface 1/2 time to 3 times deeper than the size of a grain (51a) of said plate (51), which grain size is in the range of 1 micrometers to 3 micrometers, and ceramic plates (52a, 52b) of Sic are CVD or sputter deposited onto said aluminium oxide film (56) and thus arranged between said aluminium oxide film (56) and said brazing alloy.

## Patentansprüche

1. Keramisches Substrat für die Verwendung für einen elektrischen oder elektronischen Schaltkreis, bestehend aus
a) einem keramischen Schichtenaufbau (51/56/52a/52b) mit einer keramischen Platte (51), die im wesentlichen aus Aluminiumnitrid (AIN) zusammengesetzt ist, einem Aluminiumoxidfilm (56), der die Oberfläche der keramischen Platte (51) bedeckt und eine Dicke von ungefähr 0,5 µm bis ungefähr 30 µm hat;
b) metallischen Platten (53a, 55a) aus einer Substanz, die aus der Gruppe bestehend aus Aluminium und Aluminiumlegierungen ausgewählt sind und mit einer Oberfläche der keramischen Schichtenfolge verbunden sind, und eine Leitungsverbindung mit wenigstens einer mit ihnen verbundenen Schaltkreiskomponente herstellen, wobei die metallischen Platten an die eine Oberfläche der keramischen Schichtenfolge mit einer Lötlegierung (54a) gelötet sind, die aus der Gruppe bestehend aus Aluminiumsilber-Legierung, Aluminiumgermanium-Legierung und Aluminiumkupfer-Legierung ausgewählt ist;
**dadurch gekennzeichnet,** daß
die Oberfläche der Aluminiumnitridplatte (51) eine rauhe Oberfläche mit Spalten (57) ist, die um ein 1/2-faches bis ein 3-faches tiefer in die Oberfläche hineinreichen, als die Komgröße (51a) der Platte (51), wobei die Komgröße in dem Bereich von 1 µm bis 3 µm ist, und die keramischen Platten (52a, 52b) aus SIC mittels CVD oder Sputter-Abscheidung auf dem Aluminiumoxidfilm (56) abgeschieden sind und so zwischen dem Aluminiumoxidfilm (56) und der Lötlegierung angeordnet sind.

## Revendications

1. Substrat céramique utilisé pour un circuit électrique ou électronique comprenant
a) une base céramique (51/56/52a/52b) réalisée à partir d'une plaque céramique (51) essentiellement composée de nitrure d'aluminium (AIN), une pellicule d'oxyde d'aluminium (56) recouvrant la surface de ladite plaque céramique (51) et ayant une épaisseur d'environ 0,05 µm à environ 30 µm).
b) des plaques métalliques (53a/53b) d'une substance choisie parmi l'ensemble constitué par l'aluminium et les alliages d'aluminium, liée à une surface de ladite base céramique et fournissant un chemin conducteur pour au moins un composant de circuit qui lui est rattaché, lesdites plaques métalliques étant brasées à ladite surface de ladite base céramique au moyen d'un alliage de brasure (54a) choisi parmi l'ensemble constitué par les alliages d'aluminium-silicium, d'aluminium-germanium et d'aluminium-cuivre,
caractérisé en ce que
ladite surface de ladite plaque (51) de nitrure d'aluminium est une surface rugueuse avec des évidements (57), qui pénètrent dans la surface 1/2 à 3 fois plus profondément que la dimension du grain (51a) de ladite plaque (51), ladite dimension de grain se situant dans l'intervalle de 1 µm à 3 µm, et les plaques céramiques (52a, 52b) de SiC sont déposées par projection ou dépôt en phase vapeur sur ladite pellicule d'oxyde d'aluminium (56) et sont ainsi disposées entre ladite pellicule d'oxyde d'aluminium (56) et ledit métal de brasure.
